# EUROPEAN PATENT APPLICATION

(11) **EP 4 661 060 A1**
(43) Date of publication of application: **10.12.2025**
(21) Application number: 24749871.0
(22) Date of filing: 09.01.2024
(51) Int. Cl.: H01L 21/365, C23C 16/44, C23C 16/448, H01L 21/368

(54) **NOZZLE CLEANING METHOD, FILM FORMATION METHOD FOR FORMING CRYSTALLINE OXIDE FILM, AND FILM FORMATION DEVICE**

(30) Priority: 31.01.2023 JP 2023012474
(71) Applicant: SHIN-ETSU CHEMICAL CO., LTD., Tokyo 1000005 (JP)
(72) Inventor: WATABE, Takenori, Annaka-shi, Gunma 379-0195 (JP)
(74) Representative: Schicker, Silvia
(86) International application number: PCT/JP2024/000203
(87) International publication number: WO 2024/161915

(57) **Abstract**

The present invention provides a nozzle cleaning method in a film formation apparatus comprising: a stage configured to heat a substrate placed on the stage; and a film formation unit including a nozzle configured to supply a mist of a film forming raw material, containing gallium, accompanied by a carrier gas to the substrate, the supplied mist reacting on the heated substrate to thereby form a crystalline oxide film containing gallium as a main component on the substrate, the method comprising a cleaning process, wherein a cleaning agent containing at least water in a liquid state or a gas state is supplied to the nozzle to remove a product adhering to the nozzle during film formation. Thus, the nozzle cleaning method can be provided so that the nozzle to which the product adheres during film formation can be prevented from constituting a source of particle generation.

## Description

### TECHNICAL FIELD

The present invention relates to a nozzle cleaning method, a crystalline oxide film formation method, and a film formation apparatus.

### BACKGROUND ART

Mist Chemical Vapor Deposition (Mist CVD, hereinafter also referred to as "mist CVD method") has been developed in which a thin film is formed on a substrate by using a raw material atomized into a mist form, and this method has been utilized to prepare an oxide semiconductor film or the like (Patent Document 1). As an example of the mist CVD method, a method for supplying mist to a substrate through a nozzle is also disclosed in Patent Documents 2 and 3.

### CITATION LIST

### PATENT LITERATURE

Patent Document 1: JP 2013-028480 A
Patent Document 2: JP 2014-063973 A
Patent Document 3: JP 2021-136445 A

### SUMMARY OF INVENTION

### TECHNICAL PROBLEM

However, a method for atomizing a raw material to form a high-quality film has not been established yet, and there is a problem that numerous particles due to the quality of raw material mist adhere to the formed film. Moreover, it is known that when a mist is supplied in larger amount to increase a film formation rate, such particles adhere more noticeably, and it has been desired to achieve both high film quality and productivity.

To solve this problem, Patent Document 3 discloses a method for controlling the atomizing method to suppress generation of particles. This method is effective as a method for reducing the generation of particles. In the method, however, as a film formation time is lengthened to form a thicker film, mist tends to agglomerate in a nozzle, and a product adhering to a nozzle wall surface or the like tends to desorb, float, and turn into particles. Therefore, it is preferable if the product can be more reliably prevented from constituting a source of particle generation.

The present invention has been made to solve the above problems, and an object of the present invention is to provide a nozzle cleaning method capable of preventing a product adhering to a nozzle from constituting a source of particle generation during film formation; and a film formation method and a film formation apparatus that enable efficient formation of a high-quality thin film with particle adhesion suppressed.

### SOLUTION TO PROBLEM

To achieve the above object, the present invention provides a nozzle cleaning method in a film formation apparatus comprising: a stage configured to heat a substrate placed on the stage; and a film formation unit including a nozzle configured to supply a mist of a film forming raw material, containing gallium, accompanied by a carrier gas to the substrate, the supplied mist reacting on the heated substrate to thereby form a crystalline oxide film containing gallium as a main component on the substrate,
the method comprising a cleaning process, wherein a cleaning agent containing at least water in a liquid state or a gas state is supplied to the nozzle to remove a product adhering to the nozzle during film formation.

According to the nozzle cleaning method, since the product adhering to the nozzle during film formation is removed with the cleaning agent containing water, the adhering product is removed from the nozzle before desorbing, floating, and turning into particles. Therefore, the product adhering to the nozzle during film formation can be prevented from constituting a source of particle generation.

In addition, according to the nozzle cleaning method, since a versatile cleaning agent containing water is used to remove the product, the nozzle can be cleaned inexpensively and provide safety during cleaning.

Furthermore, incorporating the cleaning method into a method for forming a crystalline oxide film results in a high-quality crystalline oxide film with a significantly reduced particle density on the surface of the film. In addition, it is possible to produce a crystalline oxide film at low cost.

In the cleaning process, when supplying the cleaning agent to the nozzle, the temperature of the nozzle may be set to 50 to 250°C.

According to the cleaning method, by setting the temperature of the nozzle in the cleaning process to 50°C or higher, it is possible to inhibit the cleaning agent from remaining on the surface of the nozzle after cleaning, and to promote a reaction in which the product is dissolved in the cleaning agent. Furthermore, by setting the temperature of the nozzle in the cleaning process to 250°C or lower, it is possible to reliably cause a reaction in which the product is dissolved in the cleaning agent and removed.

Therefore, when a film forming process is subsequently performed, it is possible to obtain a high-quality crystalline oxide film with the more significantly reduced particle density on the film surface.

In the cleaning process, water or water vapor containing acid may be supplied as the cleaning agent.

According to the cleaning method, the acid can promote the reaction in which the product is dissolved in the cleaning agent and removed. Therefore, when the film forming process is subsequently performed, it is possible to obtain a high-quality crystalline oxide film with the further significantly reduced particle density on the film surface.

In the cleaning process, the cleaning agent may be supplied to the nozzle as the mist.

In this way, by supplying the cleaning agent as mist, an atomizing device identical to that used to atomize the film forming raw material during film forming process can be used in supplying the cleaning agent. Therefore, a dedicated device for supplying the cleaning agent does not necessarily have to be prepared for cleaning, and the cleaning process can be performed at low cost. Furthermore, incorporating the cleaning method into the method for forming the crystalline oxide film can produce a crystalline oxide film at low cost.

The stage may be configured to be able to place the substrate with a diameter of 4 inches (100 mm) to 8 inches (200 mm).

By using the stage on which a large-area substrate can be placed in this manner, when the film forming process is subsequently performed, it is possible to obtain a high-quality crystalline oxide film with the more significantly reduced particle density on the film surface even for the large-area substrate.

In the cleaning process, the nozzle may be heated with a heating device that is different from a device that heats the stage.

Since the nozzle is heated with the heating device different from the device that heats the stage in this manner, the nozzle can be efficiently heated to a high temperature with a smaller amount of heat as compared with a case where the stage is heated using the device that heats the stage, and the nozzle is heated by heat conduction through the stage and an atmosphere in the device, resulting cost of the cleaning process can be reduced.

Furthermore, since the nozzle is heated with the heating device different from the device that heats the stage, depending on arrangement and structure of the heating device, the nozzle can be heated uniformly as compared with the case where the nozzle is heated with the device that heats the stage. Therefore, a degree of product removal depending on the position of the nozzle surface is less likely to be uneven. When the film forming process is subsequently performed, it is possible to efficiently obtain a high-quality crystalline oxide film with the more significantly reduced particle density on the film surface.

Furthermore, the present invention provides a crystalline oxide film formation method, comprising: a film forming process including: supplying a mist of a film forming raw material, containing gallium, accompanied by a carrier gas through a nozzle to a substrate placed on a heated stage to cause the mist to react on the substrate; and forming a crystalline oxide film containing gallium as a main component on the substrate; and the aforementioned cleaning process that is performed each time the film forming process is performed for a predetermined time.

Thus, the nozzle is cleaned to remove adhered materials each time the film forming process is performed for the predetermined time, so that the product adhering to the nozzle is removed from the nozzle before desorbing, floating, and turning into particles. Therefore, it is possible to obtain a high-quality crystalline oxide film with the significantly reduced particle density on the film surface. In addition, it is possible to produce the crystalline oxide film at low cost and to provide safety in producing the crystalline oxide film.

Furthermore, the present invention provides a film formation apparatus comprising: a stage configured to heat a substrate placed on the stage; a film formation unit including a nozzle configured to supply a mist of a film forming raw material accompanied by a carrier gas to the substrate; and a raw material supply unit configured to supply the mist to the nozzle of the film formation unit, the supplied mist reacting on the heated substrate to thereby form a film on the substrate, the film formation apparatus further comprising: a cleaning agent supply unit configured to supply a cleaning agent containing at least water in a liquid state or a gas state to the nozzle.

Thus, since the film formation apparatus includes the cleaning agent supply unit and the nozzle is cleaned to remove adhered materials each time film formation is performed for the predetermined time, the product adhering to the nozzle is removed from the nozzle before desorbing, floating, and turning into particles. Therefore, it is possible to obtain a high-quality film with a significantly reduced particle density on the film surface. In addition, it is possible to produce the film at low cost and to provide safety in producing the film.

This film formation apparatus may comprise a controller configured to control the raw material supply unit and the cleaning agent supply unit so as to perform cleaning, each time film formation is performed for a predetermined time, by supplying the cleaning agent from the cleaning agent supply unit to the nozzle to thereby remove a product adhering to the nozzle during film formation.

Consequently, since the controller is provided to control the raw material supply unit and the cleaning agent supply unit so as to perform cleaning each time film formation is performed for the predetermined time, it is possible to automatically switch between the film formation and the cleaning.

### ADVANTAGEOUS EFFECTS OF INVENTION

As described above, according to a nozzle cleaning method of the present invention, a product adhering to a nozzle during film formation can be prevented from constituting a source of particle generation. Therefore, when a film forming process is performed after cleaning, it is possible to obtain a high-quality crystalline oxide film with a significantly reduced particle density on a film surface.

Furthermore, according to a crystalline oxide film formation method of the present invention, a high-quality crystalline oxide film can be efficiently formed with particle adhesion suppressed. In addition, it is possible to form the crystalline oxide film at low cost and to provide safety during the formation of the crystalline oxide film.

In addition, according to the film formation apparatus of the present invention, it is possible to efficiently form a high-quality film with particle adhesion suppressed. It is also possible to form the film at low cost and to provide safety in forming the film.

Furthermore, nozzle clogging is suppressed by cleaning the nozzle, so that an effect of suppressing deterioration of film thickness distribution as well as an effect of suppressing a decrease in film formation rate can be obtained. In addition, when doping is performed, an effect of suppressing nozzle contamination (memory effect) by doping elements can be obtained.

### BRIEF DESCRIPTION OF DRAWINGS

FIG. 1 is a schematic illustration showing an example of a configuration of a semiconductor device using a laminated structure including a crystalline oxide film produced by a crystalline oxide film formation method according to the present invention;
FIG. 2 is a schematic illustration showing an example of a configuration of a film formation apparatus (mist CVD apparatus) suitable for use in forming a crystalline oxide film according to the present invention;
FIG. 3 is an explanatory illustration of an example of an atomizing unit of the film formation apparatus for use in the present invention;
FIG. 4 is a schematic illustration showing another example of the configuration of the film formation apparatus (mist CVD apparatus) suitable for use in forming the crystalline oxide film according to the present invention, including a cleaning water atomizing unit for atomizing water as a cleaning agent in addition to an atomizing unit for atomizing a raw material solution; and
FIG. 5 is a schematic illustration showing still another example of the configuration of the film formation apparatus (mist CVD apparatus) suitable for use in forming the crystalline oxide film according to the present invention, including a water vapor generation source that supplies water as a cleaning agent in water vapor.

### DESCRIPTION OF EMBODIMENTS

Hereinafter, the present invention will be described in detail, but the present invention is not limited thereto.

As described above, there have been demands for: a nozzle cleaning method that can prevent a product adhering to a nozzle during film formation from constituting a source of particle generation; and crystalline oxide film formation method and apparatus for forming a high-quality crystalline oxide film with a significantly reduced particle density on a film surface.

The present inventor has earnestly studied the above problems and consequently found that by a nozzle cleaning method in a film formation apparatus including: a stage configured to heat a substrate placed on the stage; and a film formation unit including a nozzle configured to supply a mist of a film forming raw material, containing gallium, accompanied by a carrier gas to the substrate, the supplied mist reacting on the heated substrate to thereby form a crystalline oxide film containing gallium as a main component on the substrate, the method including a cleaning process, wherein a cleaning agent containing at least water in a liquid state or a gas state is supplied to the nozzle to remove a product adhering to the nozzle during film formation, it is possible to prevent the nozzle to which the product adheres during film formation from constituting a source of particle generation and to obtain a high-quality crystalline oxide film with a significantly reduced particle density on a film surface when a film forming process is performed after cleaning. This finding has led to the completion of the present invention.

As another consequence of the earnest studies of the above problems, the present inventor has found that by a crystalline oxide film formation method, the method including: a film forming process including: supplying a mist of a film forming raw material, containing gallium, accompanied by a carrier gas through a nozzle to a substrate placed on a heated stage to cause the mist to react on the substrate; and forming a crystalline oxide film containing gallium as a main component on the substrate; and the aforementioned cleaning process that is performed each time the film forming process is performed for a predetermined time, it is possible to obtain a high-quality crystalline oxide film with a significantly reduced particle density on a film surface . This finding also has led to the completion of the present invention.

As a further consequence of the earnest studies of the above problems, the present inventor has found that by a film formation apparatus including: a stage configured to heat a substrate placed on the stage; a film formation unit including a nozzle configured to supply a mist of a film forming raw material accompanied by a carrier gas to the substrate; and a raw material supply unit configured to supply the mist to the nozzle of the film formation unit, the supplied mist reacting on the heated substrate to thereby form a film on the substrate, the film formation apparatus further including: a cleaning agent supply unit configured to supply a cleaning agent containing at least water in a liquid state or a gas state to the nozzle, it is possible to form a high-quality film with a significantly reduced particle density on a film surface. This finding also has led to the completion of the present invention.

Hereinafter, embodiments suitable for the present invention will be described with reference to the drawings.

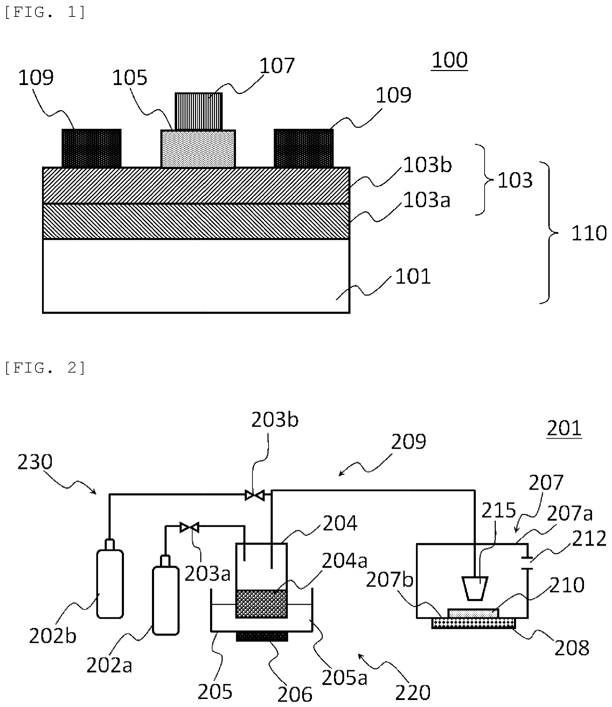

First, with reference to FIG. 1, a suitable example of a semiconductor device 100 will be described using a crystalline oxide film 103 produced by a method for forming the crystalline oxide film 103, including a nozzle cleaning method according to an embodiment of the present invention.

As shown in FIG. 1, in the semiconductor device 100, the crystalline oxide film 103 is formed on a base substrate 101, and the base substrate 101 and the crystalline oxide film 103 constitute a laminated structure 110. The crystalline oxide film 103 is composed of an insulating thin film 103a and a semiconductor thin film 103b laminated in order from a base substrate 101 side. A gate insulating film 105 is formed on the semiconductor thin film 103b. A gate electrode 107 is formed on the gate insulating film 105. Furthermore, source/drain electrodes 109 are formed on the semiconductor thin film 103b to sandwich the gate electrode 107 therebetween. According to this configuration, a gate voltage applied to the gate electrode 107 enables control of a depletion layer formed in the semiconductor thin film 103b, and a transistor operation (FET device) is possible. Examples of the semiconductor device that can be formed using the crystalline oxide film 103, produced by the film formation method according to the present invention include; transistors and TFTs such as MIS, HEMT, and IGBT; Schottky barrier diodes utilizing semiconductor-metal junctions; PN or PIN diodes combined with other P layers; and light-receiving and light-emitting elements. The crystalline oxide film 103 according to the present invention is useful for improving characteristics of these devices.

### (Crystalline Oxide Film)

The crystalline oxide film 103 produced by the crystalline oxide film 103 formation method according to the present invention has a particle density of 50 /cm² or less of particles with a diameter of 0.3 µm or more on the surface of the crystalline oxide film 103. Particles with a diameter of 0.3 µm or more have a significant effect on characteristics of the semiconductor device 100 when the device is manufactured based on the crystalline oxide film 103. The crystalline oxide film 103 as described above having a particle density of 50 /cm² or less of particles with a diameter of 0.3 µm or more is of a high-quality suitable for manufacturing the semiconductor device.

Note that in the present invention, the term "particles" include particles incorporated in the crystalline oxide film 103 and integrated with the film, and particles adhering as foreign matter to the surface of the crystalline oxide film 103 and refer to particles observed as particles when the surface of the film is observed. The diameter of the particles is a value based on a particle size that is measured with a light-scattering particle measurement instrument. The particle size is determined through calibration of the measurement instrument with reference particles of multiple sizes.

That is, the diameter of the particles is a value classified by comparing a measurement value of particles, measured with the measurement instrument, with a measurement value of reference particles, measured with the measurement instrument. The particles on the surface of the crystalline oxide film 103 can be measured, for example, with a laser scattering-based particle counter. It is also possible to observe the film surface using an optical microscope and count the number of particles by size.

The crystalline oxide film 103 is generally composed of metal and oxygen, and in the crystalline oxide film 103 according to the present invention, it is preferable that gallium is a main component as a metal. Note that in the present invention, "gallium as the main component" means that 50 to 100 atm% of the metal component is gallium. Examples of the metal component other than gallium include one or more metals selected from iron, indium, aluminum, vanadium, titanium, chromium, rhodium, iridium, nickel, and cobalt. In the following description, unless otherwise mentioned, a case where the crystalline oxide film 103 is mainly composed of gallium will be described as an example.

The crystalline oxide film may contain a dopant element. Examples of the dopant element include n-type dopants such as tin, germanium, silicon, titanium, zirconium, vanadium, niobium, and the like; and p-type dopants such as copper, silver, iridium, rhodium, magnesium, and the like, and are not particularly limited thereto. A concentration of a dopant may be, for example, from about 1×10¹⁶/cm³ to 1×10²²/cm³, a low concentration of about 1×10¹⁷/cm³ or less, or a high concentration of about 1×10²⁰/cm³ or more.

A crystal structure of the crystalline oxide film 103 is not particularly limited, and may be a β-gallia structure, a corundum structure, or an orthorhombic crystal structure. The film may include mixed crystal structures or a polycrystalline structure and is preferably a single crystal film or a uniaxially oriented film. It can be confirmed whether the film is the single crystal film or the uniaxially oriented film by an X-ray diffractometer, an electron diffractometer, or the like. When the film is irradiated with X-rays or electron beams, a diffraction image corresponding to the crystal structure can be obtained, and when the film is uniaxially oriented, only a specific peak appears. Consequently, it can be determined that the film is uniaxially oriented.

The film thickness of the crystalline oxide film 103 is not particularly limited and is preferably 0.1 µm or more. An upper limit is not particularly limited. For example, the film thickness may be 100 µm or less and is preferably 50 µm or less, and more preferably 30 µm or less. The film thickness can be measured by a stylus type step meter, a reflective spectroscopic film thickness meter, an ellipsometer, and observation of a cross section with SEM or TEM, either of which may be used.

The crystalline oxide film 103 can be obtained by being formed by a mist CVD method using a mist CVD apparatus (film formation apparatus 201, 201a, or 201b) described later.

### (Base Substrate)

The base substrate 101 for forming the crystalline oxide film 103 by the film formation method according to the present invention is not particularly limited if it serves as a support for the crystalline oxide film 103. A material thereof is not particularly limited and may be a known substrate, an organic compound, or an inorganic compound. Examples of the material include polysulfones, polyethersulfones, polyphenylene sulfides, polyetheretherketones, polyimides, polyetherimides, fluororesins, metals such as iron, aluminum, stainless steel and gold, quartz, glass, calcium carbonate, gallium oxide, ZnO and the like. Additionally, a single crystal substrate made of silicon, sapphire, lithium tantalate, lithium niobate, SiC, GaN, iron oxide, chromium oxide, or the like is exemplified as the base substrate, and is preferably the single crystal substrate as described above in the present invention. Consequently, a higher quality crystalline oxide film 103 can be obtained. Particularly, a sapphire substrate, a lithium tantalate substrate and a lithium niobate substrate are comparatively inexpensive and industrially advantageous.

The base substrate 101 preferably has a thickness of 100 to 5000 µm. In such a range, the base substrate is easy to handle, and thermal resistance can be reduced during film formation, so that a high-quality film can be easily obtained.

A size of the base substrate 101 is not particularly limited, and the base substrate 101 with an area of 100 mm² or more or a diameter of 2 inches (50 mm) or more is preferable in that a large-area film with excellent crystallinity can be obtained. Furthermore, if the diameter of the base substrate 101 is from 4 inches (100 mm) to 8 inches (200 mm), the resulting crystalline oxide film 103 can be easily processed using an existing processing apparatus, and the base substrate is industrially advantageous in manufacturing a semiconductor device. In addition, since the base substrate has an excellent film thickness distribution with the large area, when applied to the semiconductor device, excellent semiconductor characteristics can be obtained. For example, when a semiconductor device such as a power semiconductor device is manufactured from the crystalline oxide film 103, a product lot including two or more of the semiconductor devices can have a breakdown voltage yield of 75% or more.

Another layer may be interposed between the base substrate 101 and the crystalline oxide film 103. The layer is generally a layer having a different composition from the base substrate 101 and the outermost crystalline oxide film 103 and is also referred to as a buffer layer. The buffer layer may be either an oxide semiconductor film, an insulating film, a metal film, or the like, and examples of a material include Al₂O₃, Ga₂O₃, Cr₂O₃, Fe₂O₃, In₂O₃, Rh₂O₃, V₂O₃, Ti₂O₃, Ir₂O₃, and the like, or mixed crystals thereof being suitably used. The thickness of the buffer layer is preferably from 0.1 µm to 2 µm.

Next, a nozzle cleaning method according to the present invention using the mist CVD apparatus and a crystalline oxide film 103 forming method including the nozzle cleaning method will be described. Here, the mist in the present invention refers to a general term for fine particles of a liquid dispersed in a gas, and includes those called fog, droplets, and the like.

### (Film Formation Apparatus)

FIG. 2 schematically shows a film formation apparatus 201 that forms a film by a mist CVD method. The film formation apparatus 201 includes at least: an atomizing unit 220 that atomizes a raw material solution 204a to generate mist; a carrier gas supply unit 230 that supplies a carrier gas that conveys the mist; a supply pipe 209 connecting the atomizing unit 220 to a film formation unit 207 so that the mist is conveyed with the carrier gas; and the film formation unit 207 that thermally treats the mist to form the film on a substrate 210.

### (Atomizing Unit)

In the atomizing unit 220, the raw material solution 204a is atomized to generate mist. Atomizing means is not particularly limited only if the raw material solution 204a can be atomized, and may be a known atomizing means, but it is preferable to use the atomizing means by ultrasonic vibration. This is because the solution can be atomized more stably.

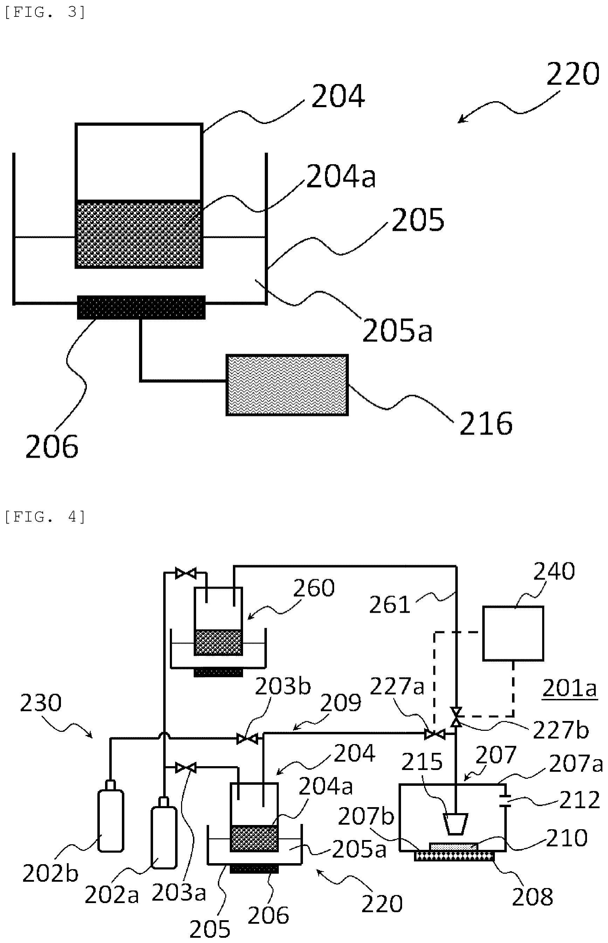

FIG. 3 shows an example of the atomizing unit 220. The atomizing unit 220 may include a mist generation source 204 in which the raw material solution 204a containing gallium is stored, a container 205 in which a medium capable of transmitting ultrasonic vibrations, such as water 205a, is contained, and an ultrasonic transducer 206 attached to a bottom surface of the container 205.

Specifically, the mist generation source 204 including a container in which the raw material solution 204a is stored can be contained in the container 205 in which the water 205a is stored, using a support (not shown). The ultrasonic transducer 206 may be provided at the bottom of the container 205, and the ultrasonic transducer 206 may be connected to an oscillator 216. Then, when the oscillator 216 is operated, the ultrasonic transducer 206 is vibrated, ultrasonic waves are propagated into the mist generation source 204 via the water 205a, and the raw material solution 204a can be atomized.

### (Raw Material Solution)

The raw material solution 204a is not particularly limited to any material contained in the solution as long as atomizing is possible and may be an inorganic material or an organic material. As the material, a metal or metal compound is preferably used, and a material including one or more metals selected from gallium, iron, indium, aluminum, vanadium, titanium, chromium, rhodium, nickel, and cobalt may be used.

As the raw material solution 204a described above, a solution of which a metal is dissolved or dispersed in an organic solvent or water in the form of a complex or salt can be used suitably. Examples of the salt form include halide salts such as metal chloride salts, metal bromide salts, metal iodide salts, and the like. Furthermore, a solution in which the above metal dissolved in hydrogen halide such as hydrobromic acid, hydrochloric acid, hydroiodic acid, or the like can be used as a salt solution. Examples of the form of the complex include acetylacetonate complexes, carbonyl complexes, ammine complexes, hydride complexes, and the like. An acetylacetonate complex can be formed also by mixing acetylacetone with the salt solution. A metal concentration in the raw material solution 204a is not particularly limited and may be from 0.005 to 1 mol/L or the like. The temperature during mixing and dissolving is preferably 20°C or higher.

The raw material solution 204a may be mixed with an additive such as hydrohalic acid or an oxidizing agent. Examples of hydrohalic acid include hydrobromic acid, hydrochloric acid, hydroiodic acid, and the like, and above all, hydrobromic acid or hydroiodic acid are preferable because a high film formation rate can be obtained. Examples of the oxidizing agent include peroxides such as hydrogen peroxide (H₂O₂), sodium peroxide (Na₂O₂), barium peroxide (BaO₂), and benzoyl peroxide (C₆H₅CO)₂O₂, hypochlorous acid (HClO), perchloric acid, nitric acid, ozone water, and organic peroxides such as peracetic acid and nitrobenzene.

The raw material solution 204a may include a dopant source. The dopant source is not particularly limited. Examples of the dopant source include a n-type dopant source such as tin, germanium, silicon, titanium, zirconium, vanadium or niobium, a p-type dopant source such as copper, silver, iridium, rhodium or magnesium, and the like.

In the following description, unless otherwise mentioned, a case where a solution containing gallium is used as the raw material solution 204a will be described.

### (Carrier Gas Supply Unit)

As shown in FIG. 2, the carrier gas supply unit 230 includes a carrier gas source 202a that supplies carrier gas to the atomizing unit 220. At this time, a flow rate adjustment valve 203a for adjusting the flow rate of the carrier gas sent out from the carrier gas source 202a may be provided in a pipe connecting the carrier gas source 202a to the atomizing unit 220. Furthermore, the carrier gas supply unit may include a diluting carrier gas source 202b for supplying a diluting carrier gas, and a flow rate adjustment valve 203b for adjusting the flow rate of the diluting carrier gas sent out from the diluting carrier gas source 202b as necessary. Note that in the present invention, the sum of a carrier gas flow rate and a diluting carrier gas flow rate is referred to as a total carrier gas flow rate.

The type of carrier gas is not particularly limited and can be appropriately selected depending on a film formed. Examples thereof include oxidizing gases such as oxygen and ozone, inert gases such as nitrogen and argon, reducing gases such as hydrogen gas and forming gas, and the like.

Furthermore, the number of types of carrier gas may be one or more. For example, as a second carrier gas, a diluted gas obtained by diluting the same gas as a first carrier gas with another gas (for example, diluted 10 times) may be further used, and air can also be used. The total carrier gas flow rate is not particularly limited. For example, when a film is formed on a substrate with a diameter of 2 inches (about 50 mm), the total carrier gas flow rate is preferably from 0.05 to 50 NL/minute, and more preferably from 5 to 20 NL/minute. Note that the unit NL/minute represents the flow rate converted to 0°C and 1 atmospheric pressure (101325 Pa).

### (Supply Pipe)

The film formation apparatus 201 includes the supply pipe 209 connecting the atomizing unit 220 to the film formation unit 207. In this case, mist is conveyed with the carrier gas through the supply pipe 209 from the mist generation source 204 of the atomizing unit 220 and supplied to the film formation unit 207. The supply pipe 209 can use, for example, a quartz tube, a glass tube, a resin tube, or the like. Furthermore, when the film formation apparatus 201 includes the diluting carrier gas source 202b, the diluting carrier gas source 202b is connected to the middle of the supply pipe 209.

In addition, the supply pipe 209, the carrier gas supply unit 230, and the atomizing unit 220 constitute a raw material supply unit that supplies mist to a nozzle 215 of the film formation unit 207.

### (Film Formation Unit)

The film formation unit 207 includes a film formation chamber 207a that is a container in which film formation is performed, and a stage 207b on which the substrate 210 is placed is provided in the film formation chamber 207a. The stage 207b is also configured to heat the substrate 210 placed on the stage and includes a heater 208 for heating the substrate 210. The stage 207b heats the substrate 210 by transmitting heat generated by the heater 208 to the substrate 210. Here, the bottom surface of the film formation chamber 207a is shown as the stage 207b. The heater 208 may be provided outside the film formation chamber 207a, for example, as shown in FIG. 2, or may be provided inside the film formation chamber 207a.

The stage 207b needs to have a dimension that allows the substrate 210 to be placed. For example, the stage 207b may be configured to be able to place the substrate 210 with a diameter of 4 inches (100 mm) to 8 inches (200 mm).

By using the stage 207b on which the large-area substrate 210 can be placed in this manner, a film forming process can result in the high-quality crystalline oxide film 103 with the significantly reduced particle density on the film surface even relative to the large-area substrate 210.

In the film formation unit 207, one end of the supply pipe 209 is provided within the film formation chamber 207a, and a film forming gas supplied from the supply pipe 209 and the mist accompanied by the gas can be introduced into the film formation chamber 207a. The film formation unit 207 includes the nozzle 215 that is connected to one end of the supply pipe 209 in the film formation chamber 207a and that supplies a mist of film forming raw material containing gallium to the substrate 210, and the film forming gas is jetted from the nozzle 215 toward the substrate 210.

As shown in FIG. 2, an exhaust gas port 212 may be provided on an outer wall of the film formation chamber 207a of the film formation unit 207.

Furthermore, in the film formation chamber 207a of the film formation unit 207, a top plate or the like (not shown) for rectifying the supplied mist on the substrate may be provided.

Furthermore, the substrate 210 may be placed on the stage 207b provided on an upper surface of the film formation unit 207 to face downward, or the substrate 210 may be placed on the stage 207b provided on an upper surface of a bottom surface of the film formation unit 207 to face upward. FIG. 1 illustrates that the substrate 210 faces upward.

In addition, the heater 208 or the nozzle 215 may be connected to a conveying mechanism (not shown) and may be movable in a reciprocating motion, a rotational motion, or the like. Performing the movement operations during film formation improves the uniformity of the resulting film.

### (Film Formation Method)

The mist CVD method includes a mist generating process of atomizing the raw material solution 204a to generate mist in the atomizing unit 220; a carrier gas supplying process of supplying a carrier gas for conveying the mist to the atomizing unit 220; a conveying process of conveying the mist with the carrier gas from the atomizing unit 220 to the film formation unit 207 through the supply pipe 209 connecting the atomizing unit 220 to the film formation unit 207; and a film forming process of thermally treating the conveyed mist to form a film on the substrate 210 that is a base substrate. In the present invention, the method also includes the cleaning process of cleaning the nozzle 215.

First, the method includes placing the substrate 210 on the stage 207b in the film formation unit 207, to operate the heater 208; then opening the flow rate adjustment valves 203a and 203b to supply the carrier gas from the carrier gas source 202a and the diluting carrier gas source 202b into the film formation unit 207, to sufficiently replace the atmosphere in the film formation unit 207 with the carrier gas; and then adjusting each of the flow rate of the carrier gas and the flow rate of the diluting carrier gas.

Next, after storing the prepared raw material solution 204a in the mist generation source 204, the mist generating process is performed, which includes vibrating the ultrasonic transducer 206, propagating the vibration through the water 205a to the raw material solution 204a, and thereby atomizing the raw material solution 204a to generate mist.

Next, the carrier gas supplying process is performed, which includes supplying the carrier gas for conveying mist from the carrier gas source 202a to the atomizing unit 220.

Next, the conveying process is performed, which includes conveying the mist with the carrier gas from the atomizing unit 220 to the nozzle 215 in the film formation unit 207 via the supply pipe 209 connecting the atomizing unit 220 to the film formation unit 207.

Next, the film forming process is performed, which includes jetting, from a tip of the nozzle 215 to the substrate 210, the mist of the film forming raw material containing gallium, accompanied by the carrier gas conveyed to the nozzle 215 to supply the mist to the substrate 210; heating the mist by heat conduction from the heated substrate 210 to cause a heat reaction on the substrate 210; and forming the crystalline oxide film 103 containing gallium as the main component on the substrate 210.

Thus, in the film forming process, the film formation apparatus 201 causes the mist supplied from the nozzle 215 to react on the heated substrate 210 and thereby forms the crystalline oxide film 103 containing gallium as the main component on the substrate 210.

The substrate 210 or the nozzle 215 may be connected to an unshown conveying mechanism to perform movement in the reciprocating motion, rotational motion, or the like during film formation. Performing the movement operations further improves the uniformity of the resulting film.

The heat reaction of the mist also depends on the temperature of the environment around the substrate. Therefore, it is desirable that the temperature of the nozzle 215 during film formation and the inner wall of the film formation chamber 207a of the film formation unit 207 be higher than room temperature. This is because the heat reaction is stable. For example, the nozzle temperature can be set from 50 to 250°C.

The heat reaction may be performed under any atmosphere such as a non-oxygen atmosphere, a reducing gas atmosphere, an air atmosphere, and an oxygen atmosphere, and may be appropriately set depending on the film formed. Furthermore, a reaction pressure may be under any condition such as under atmospheric pressure, under pressure, or under reduced pressure, and it is preferable to perform film formation under atmospheric pressure because an apparatus configuration can be simplified.

When the above film forming process is performed for a predetermined time, a product adheres to at least the inner wall or outer wall of the nozzle 215. If left untreated, these products will desorb and float, constituting a source of particles on the film. To remove the product, the cleaning process is performed. Specifically, in the cleaning process, the film formation apparatus 201 is used to supply a cleaning agent containing at least water in a liquid state or a gas state to the nozzle 215, thereby removing the product adhering to the nozzle 215 during film formation.

The cleaning agent is, for example, water, and when the cleaning agent is supplied in the gas state, water vapor is supplied. When the cleaning agent is water, pure water is preferable because the component in the cleaning agent does not remain in the nozzle 215 after cleaning, and tap water or the like is also acceptable.

Furthermore, the cleaning agent may be supplied in a fluid state, and it is preferable that the cleaning agent is atomized by the method described above and supplied in the form of mist accompanied by gas to the nozzle 215. The reason is that the atomizing unit 220 as the same atomizing device as the one for atomizing the film forming raw material in the film forming process can be used, and a dedicated device for supplying a cleaning agent does not necessarily have to be prepared for cleaning, so that the cleaning process can be inexpensively performed. Furthermore, since this cleaning method is incorporated in the film formation method for the crystalline oxide film 103, the crystalline oxide film 103 can be produced at low cost.

Cleaning with atomized water can be achieved by replacing the raw material solution 204a in FIG. 2 with water. Specifically, the cleaning includes storing water as the cleaning agent in place of the raw material solution 204a in the mist generation source 204; vibrating the ultrasonic transducer 206; propagating the vibration through the water 205a to the water as the cleaning agent; atomizing the water as the cleaning agent to generate mist; and supplying the mist to the nozzle 215.

As in a film formation apparatus 201a shown in FIG. 4, a cleaning water atomizing unit 260 may be separately provided in addition to an atomizing unit 220 for a raw material. The cleaning water atomizing unit 260 is connected to a carrier gas source 202a and further connected to a supply pipe 209 via a cleaning agent pipe 261. Furthermore, a cleaning agent flow rate adjustment valve 227b is provided in the cleaning agent pipe 261, and the flow rate of a cleaning agent flowing through the cleaning agent pipe 261 is adjusted. Furthermore, a raw material flow rate adjustment valve 227a is provided in the middle of the supply pipe 209 downstream from a connecting portion to a diluting carrier gas source 202b, and the flow rate of mist and carrier gas flowing through the supply pipe 209 is adjusted.

In this configuration, the cleaning water atomizing unit 260, the cleaning agent pipe 261, the cleaning agent flow rate adjustment valve 227b, and the carrier gas source 202a of a carrier gas supply unit 230 constitute a cleaning agent supply unit. Furthermore, the supply pipe 209, the carrier gas supply unit 230, the atomizing unit 220, and the raw material flow rate adjustment valve 227a constitute a raw material supply unit. That is, the raw material supply unit and the cleaning agent supply unit share the carrier gas source 202a. This configuration is operated by switching a carrier gas supply destination depending on the process. For example, in the film forming process, the carrier gas supply destination may be switched to the atomizing unit 220 for the raw material, and in the cleaning process, the carrier gas supply destination may be switched to the cleaning water atomizing unit 260.

Specific examples of the configuration to be operated in this manner can be illustrated below. First, as a controller 240, a computer is provided in the film formation apparatus 201a for controlling opening and closing of the raw material flow rate adjustment valve 227a of the raw material supply unit and the cleaning agent flow rate adjustment valve 227b of the cleaning agent supply unit.

For example, when a raw material solution 204a can be atomized and the carrier gas can be supplied, the controller 240 opens the raw material flow rate adjustment valve 227a and closes the cleaning agent flow rate adjustment valve 227b to supply an atomized film forming raw material to a nozzle 215, so that film formation is possible.

In contrast, when the controller 240 closes the raw material flow rate adjustment valve 227a and opens the cleaning agent flow rate adjustment valve 227b in a state where water as the cleaning agent can be atomized by the cleaning water atomizing unit 260 and the carrier gas can be supplied after the elapse of a predetermined time from the start of film formation, the cleaning agent, rather than the film forming raw material, is then supplied to the nozzle 215, to clean the nozzle 215.

Thus, the controller 240 controls the raw material supply unit and the cleaning agent supply unit to perform a cleaning process in which the cleaning agent containing at least water in a liquid state or a gas state is supplied from the supply unit to the nozzle 215 to remove the product adhering to the nozzle 215 during film formation each time film formation is performed for a predetermined time, so that switching between the film forming process and the cleaning process can be automatically performed.

The switching by the controller 240 referred to here includes a case where the controller 240 performs all operations required for switching between the film forming process and the cleaning process such as opening and closing of the raw material flow rate adjustment valve 227a and the cleaning agent flow rate adjustment valve 227b; and a case where, for example, after the elapse of a certain time from the start of film formation, the controller 240 lights a lamp or sounds a buzzer to prompt an operator to switch to cleaning, so that the operator opens and closes the raw material flow rate adjustment valve 227a and the cleaning agent flow rate adjustment valve 227b.

Furthermore, switching between the film forming process and the cleaning process by the controller 240 can be performed even when the film formation apparatus 201 shown in FIG. 2 is used. In this case, the raw material supply unit also serves as the cleaning agent supply unit.

Furthermore, the switching between the film forming process and the cleaning process with the raw material flow rate adjustment valve 227a and the cleaning agent flow rate adjustment valve 227b is an example; and, for example, the controller 240 may switch between the film forming process and the cleaning process by controlling the atomizing unit 220 and the cleaning water atomizing unit 260 to generate mist alternately with the atomizing unit and with the cleaning water atomizing unit.

The controller 240 is provided as necessary, for example, when it is desired to automatically switch between the film forming process and the cleaning process, and hence the controller is not essential. In other words, when the film forming process and the cleaning process are manually switched, the controller 240 is not essential.

As in the film formation apparatus 201a, the configuration in which the cleaning water atomizing unit 260 is separately provided in addition to the atomizing unit 220 for the raw material is advantageous in that it is not necessary to replace the raw material solution 204a with the cleaning agent in a mist generation source 204 in the cleaning process.

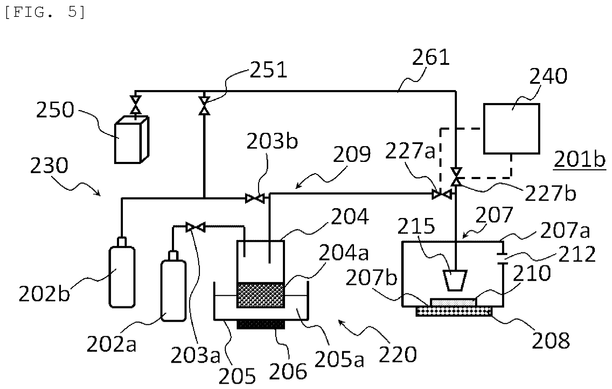

Cleaning with water vapor can be performed, for example, with a film formation apparatus 201b shown in FIG. 5. In FIG. 5, a water vapor generation source 250 is provided in place of the cleaning water atomizing unit 260, and water vapor generated from the water vapor generation source 250 is supplied to a nozzle 215 via a supply pipe 209. The water vapor may be supplied as supersaturated to the nozzle 215, or the water vapor may be supplied in an unsaturated state to the nozzle 215 accompanied by a diluting gas by adjusting a flow rate adjustment valve 251 provided in a pipe connecting a diluting carrier gas source 202b to the water vapor generation source 250.

In this case as well, a controller 240 may be provided in the film formation apparatus 201b, and the controller 240 may control a raw material flow rate adjustment valve 227a of a raw material supply unit and a cleaning agent flow rate adjustment valve 227b of a cleaning agent supply unit to perform cleaning in which a cleaning agent containing at least water in a liquid state or a gas state is supplied from the supply unit to the nozzle 215 to remove a product adhering to the nozzle 215 during film formation each time film formation is performed for a predetermined time. However, even in this case, for example, when a film forming process and a cleaning process are manually switched, the controller 240 is not essential.

It is considered that the product adhering to the nozzle 215 is a hydroxide of a metal in a raw material solution 204a. It is therefore considered that when the nozzle 215 is cleaned with the cleaning agent containing water, the hydroxide of the metal as the product adhering to the nozzle 215 adsorbs water, is dissolved in water and discharged out of a system. Therefore, water or water vapor as the cleaning agent may contain an acid such as hydrochloric acid, hydrobromic acid, hydroiodic acid, acetic acid, formic acid, or the like.

Thus, by supplying water or water vapor containing acid as the cleaning agent in the cleaning process, a reaction in which the product is dissolved in the cleaning agent and removed can be promoted by the acid. Therefore, the subsequent film forming process can obtain a higher quality crystalline oxide film 103 with a more significantly reduced particle density on a film surface.

In the cleaning process, the temperature of the nozzle 215 when supplying the cleaning agent to the nozzle 215, particularly the temperature of an outer wall of the nozzle 215 is preferably set from 50 to 250°C.

By setting the temperature of the nozzle 215 in the cleaning process to 50°C or higher, the cleaning agent can be inhibited from remaining on the nozzle surface after cleaning, and a reaction in which the product is dissolved in the cleaning agent can be promoted. Furthermore, by setting the temperature of the nozzle 215 in the cleaning process to 250°C or lower, a reaction in which the product is dissolved in the cleaning agent and removed can be reliably caused.

Therefore, the subsequent film forming process can obtain a high-quality crystalline oxide film 103 with a further significantly reduced particle density on the film surface.

Specifically, as means for controlling the temperature of the nozzle 215, means for adjusting a partial pressure of water vapor can be illustrated because when water vapor is used as the cleaning agent, the nozzle temperature changes depending on the partial pressure of water vapor.

When a liquid, such as water, is used as the cleaning agent, the nozzle 215 can be heated by a stage 207b for placing a substrate. In this case, by operating a heater 208 and heating the stage 207b, the nozzle 215 is heated by heat conduction through the stage 207b and the atmosphere in a film formation chamber 207a of the film formation apparatus 201.

In contrast, a nozzle heating mechanism as a heating device different from the heater 208, which is a device for heating the stage 207b, may be provided, and heating may be performed using this mechanism. As the nozzle heating mechanism, for example, the nozzle may be heated directly with the heater, or the nozzle may be heated directly with a medium such as hot water or water vapor through a pipe drawn around or inside the nozzle.

When heating the nozzle 215 with a heating device different from a device for heating the stage 207b in this manner, the nozzle 215 can be heated to a high temperature with less amount of heat than when heating the stage 207b with the heater 208 for heating the stage 207b and heating the nozzle 215 by heat conduction through the stage 207b and the atmosphere in the film formation chamber 207a, so that cost in the cleaning process can be reduced.

Furthermore, when heating the nozzle 215 with a heating device different from the heater 208 for heating the stage 207b, depending on arrangement and structure of the heating device, the nozzle 215 can be heated more uniformly than when heating the nozzle 215 with the heater 208. Therefore, the degree of removal of the product due to a position on the surface of the nozzle 215 is less uneven, and the subsequent film forming process can efficiently obtain a high-quality crystalline oxide film 103 with a more significantly reduced particle density on the film surface.

A supply time of water or water vapor as the cleaning agent in the cleaning process is appropriately determined depending on the flow rate, temperature, and the like, and is preferably from 5 to 120 minutes.

In addition, it is preferable to interrupt the film forming process and perform the cleaning process after performing the film forming process for a predetermined time, and it is preferable to end the cleaning process and resume the film forming process after performing the cleaning process for a predetermined time.

That is, it is preferable to perform the cleaning process each time the film forming process is performed for the predetermined time.

By repeating the film forming process and the cleaning process in this manner, it is possible to prevent the product adhering to the nozzle from adhering to the film as particles, and film formation efficiency is improved. The film formation can be performed more efficiently if the substrate 210 is replaced when interrupting the film forming process.

The predetermined time is shorter than a time required for the product adhering to the nozzle 215 in the film forming process to constitute a new source of particle generation, and it falls, for example, within a range where the number of adhering particles is acceptable based on an experimentally obtained relation between the time of the film forming process and the number of particles adhering to the crystalline oxide film 103.

### (Formation of Buffer Layer)

As described above, a buffer layer may be appropriately provided between a substrate 210 and the crystalline oxide film 103. A method for forming the buffer layer is not particularly limited, and the film can be formed by a known method such as a sputtering method or a vapor deposition method. When the mist CVD method is used as described above, the buffer layer can be formed simply by appropriately changing the composition of the raw material solution 204a.

Specifically, one or more metals selected from aluminum, gallium, chromium, iron, indium, rhodium, vanadium, titanium, and iridium and dissolved or dispersed in water in the form of a complex or salt can be suitably used as a raw material aqueous solution of the buffer layer.

Examples of the form of the complex include acetylacetonate complexes, carbonyl complexes, ammine complexes, hydride complexes, and the like. Examples of the form of salt include metal chloride salt, metal bromide salt, metal iodide salt, and the like.

Furthermore, the above metal dissolved in hydrobromic acid, hydrochloric acid, hydriodic acid, or the like can be used as an aqueous solution of salt. Also, in this case, a solute concentration is preferably from 0.005 to 1 mol/L, and a dissolution temperature is preferably 20°C or higher. Other conditions can be the same as described above to form the buffer layer. When the buffer layer is provided, the buffer layer is first formed with a predetermined thickness on the substrate 210, and then the crystalline oxide film 103 is formed by the method described above.

As a particular case of the method for forming the buffer layer, a material identical to that of the crystalline oxide film 103 may be used as the buffer layer. At this time, the film formation temperature of the buffer layer may be higher than the film formation temperature of the crystalline oxide film 103. For example, the film formation temperature of the buffer layer may be 450°C, while the film formation temperature of the crystalline oxide film 103 may be 400°C, and the film formation temperature of the buffer layer may be 500°C, while the film formation temperature of the crystalline oxide film 103 may be 450°C or the like. This further improves the crystallinity of the crystalline oxide film 103.

### (Thermal Treatment)

Furthermore, a laminated structure including the crystalline oxide film 103 and the substrate 210 formed by the film formation method for the crystalline oxide film 103 according to the present invention may be thermally treated at 200 to 600°C. Thereby, unreacted species and the like in the crystalline oxide film 103 are further removed, and a higher quality laminated structure can be obtained. The thermal treatment may be performed in air or oxygen atmosphere or may be performed in an inert gas atmosphere such as nitrogen or argon. A thermal treatment time can be appropriately determined, and can be, for example, from 5 to 240 minutes.

### (Peeling)

In the laminated structure including the crystalline oxide film 103 formed by the film formation method for the crystalline oxide film 103 according to the present invention, the crystalline oxide film 103 may be peeled off from the substrate 210 that is the base substrate. Peeling means is not particularly limited and may be known means. Examples of a method of the peeling means include means of peeling by applying a mechanical impact, means of peeling by applying heat and using heat stress, means of peeling by applying vibration such as ultrasonic waves, and means of peeling by etching. Such peeling can obtain the crystalline oxide film 103 as a self-supported film.

### EXAMPLES

Hereinafter, the present invention will be specifically described with reference to examples. However, the present invention is not limited thereto.

When storing two substrates 210 one by one in order in a film formation chamber 207a and forming a crystalline oxide film by a mist CVD method, and switching the substrate 210 to the other substrate to form the film, physical properties of the crystalline oxide film formed on the second substrate were compared between two cases where a nozzle 215 was cleaned and where the nozzle was not cleaned. Specific procedures are as follows.

### [Example 1]

Film formation was performed using a film formation apparatus 201 shown in FIG. 2. The film formation apparatus 201 includes a carrier gas source 202a configured to supply a carrier gas; a flow rate adjustment valve 203a for adjusting the flow rate of the carrier gas sent out from the carrier gas source 202a; a diluting carrier gas source 202b configured to supply a diluting carrier gas; a flow rate adjustment valve 203b for adjusting the flow rate of the diluting carrier gas sent out from the diluting carrier gas source 202b; a mist generation source 204 containing a raw material solution 204a; a container 205 containing water 205a; and an ultrasonic transducer 206 attached to the bottom surface of the container 205. A film formation unit 207 includes a stage 207b, a heater 208, and a quartz supply pipe 209 connecting the mist generation source 204 to the film formation unit 207 and includes a nozzle 215 within a film formation chamber 207a.

### (Dummy Film Formation)

Using the apparatus, dummy film formation of a gallium oxide film was performed as film formation of the crystalline oxide film 103 on the first substrate. The substrate 210 was a 4-inch (100 mm) sapphire dummy substrate, and after placing this substrate in the film formation unit 207, the heater 208 was set to 450°C, to raise the temperature.

For the raw material solution 204a, ultrapure water was used as a solvent and gallium bromide was used as a solute. A gallium concentration in the raw material solution was set to 0.1 mol/L. The raw material solution 204a was stored in the mist generation source 204. Subsequently, the flow rate adjustment valves 203a and 203b were opened to supply the carrier gas from the carrier gas source 202a and the diluting carrier gas source 202b into the film formation chamber 207a; and after replacing atmosphere of the film formation chamber 207a sufficiently with the carrier gas, the flow rate of the carrier gas was adjusted to 4 NL/minute, and the flow rate of the diluting carrier gas was adjusted to 6 NL/minute, respectively. As the carrier gas, nitrogen was used.

Next, by vibrating the ultrasonic transducer 206 at 2.4 MHz and propagating the vibration through the water 205a to the raw material solution 204a, the raw material solution 204a was atomized to generate mist. By introducing this mist with the carrier gas through the supply pipe 209 into the film formation chamber 207a and causing a heat reaction of the mist on the substrate 210, a thin film of gallium oxide was formed on the substrate 210. A film formation time was 60 minutes. After film formation, it was confirmed that a white product adhering to almost the entire surface of the outer wall of the nozzle downstream from a nozzle discharge port.

### (Nozzle Cleaning)

When the heater 208 remained at 450°C, the nozzle temperature was about 180°C. In this state, the raw material solution 204a was replaced with ultrapure water to generate mist. The flow rate of the carrier gas was adjusted to 4 NL/minute and the flow rate of the diluting carrier gas was adjusted to 6 NL/minute, respectively, and the nozzle 215 was kept at rest for 30 minutes with mist introduced into the nozzle. As a result, it was confirmed that the white product on the outer wall of the nozzle disappeared. After cleaning, the dummy substrate was removed.

### (Film Formation of Gallium Oxide Film)

Subsequently, a gallium oxide film was formed on the second substrate 210. As the substrate 210, a 4-inch (100 mm) c-plane sapphire substrate was newly prepared. After placing this substrate on the stage 207b in the film formation unit 207, the heater 208 was set to 450°C to raise the temperature, and the substrate was kept at rest for 30 minutes, to stabilize the temperature in the film formation chamber 207a including the nozzle 215.

For the raw material solution 204a, ultrapure water was used as a solvent and gallium bromide was used as a solute. The gallium concentration in the raw material solution was 0.1 mol/L. The raw material solution 204a was stored in the mist generation source 204. Subsequently, the flow rate adjustment valves 203a and 203b were opened to supply the carrier gas from the carrier gas source 202a and the diluting carrier gas source 202b into the film formation chamber 207a; and after replacing atmosphere of the film formation chamber 207a sufficiently with the carrier gas, the flow rate of the carrier gas was adjusted to 4 NL/minute, and the flow rate of the diluting carrier gas was adjusted to 6 NL/minute, respectively. As the carrier gas, nitrogen was used.

Next, by vibrating the ultrasonic transducer 206 at 2.4 MHz and propagating the vibration through the water 205a to the raw material solution 204a, the raw material solution 204a was atomized to generate mist. By introducing this mist with the carrier gas through the supply pipe 209 into the film formation chamber 207a and causing a heat reaction of the mist on the substrate 210, a thin film of gallium oxide was formed on the substrate 210. The film formation time was 60 minutes.

### (Evaluation)

It was confirmed that α-Ga₂O₃ was formed by X-ray diffraction for the thin film formed on the second substrate 210. When the rocking curve of the (006) plane of α-Ga₂O₃ was measured, the full width at half maximum was 7 seconds and represented extremely satisfactory crystallinity. In addition, when measuring the rocking curve, a four-crystal monochromator combining two channel-cut crystals is used to enhance the monochromatic nature of X-rays and to perform measurement with higher accuracy. Next, when the film thickness was measured at 25 points with a reflective spectroscopic film thickness meter F50 from Filmetrics, Inc., an average film thickness was 583 nm. Furthermore, a variation in film thickness obtained by (maximum film thickness - minimum film thickness)/(maximum film thickness + minimum film thickness) × 100(%) was as good as 1.7%.

In addition, when 69 points on the substrate surface were observed at a magnification of 50 times using an optical microscope and the presence or absence of particles on the film was confirmed, particles with a diameter of 0.3 µm or more were not confirmed in an observation range. When the particle density is calculated from the observation range, it is 29/cm² or less.

### [Example 2]

Film formation and evaluation were performed on the same conditions and by the same method as in Example 1, except that in the cleaning process, the nozzle 215, into which water mist was introduced, was kept at rest for 5 minutes.

### [Example 3]

Film formation and evaluation were performed on the same conditions and by the same method as in Example 1, except that in the cleaning process, the nozzle 215, into which water mist was introduced, was kept at rest for 120 minutes.

### [Example 4]

Film formation and evaluation were performed on the same conditions and by the same method as in Example 1, except that the film formation apparatus 201b shown in FIG. 5 was used, and in the cleaning process, the nozzle 215, into which saturated water vapor at 1 atmosphere was introduced instead of water mist, was kept at rest for 30 minutes.

### [Example 5]

Film formation and evaluation were performed on the same conditions and by the same method as in Example 1, except that in the cleaning process, an aqueous solution of 1.5 wt% hydrochloric acid was atomized and introduced, instead of water, into the nozzle 215, which was kept at rest for 30 minutes.

### [Example 6]

Film formation and evaluation were performed on the same conditions and by the same method as in Example 1, except that in the cleaning process, a heater temperature was adjusted to achieve a nozzle temperature of 50°C and the nozzle 215, into which water mist was introduced, was kept at rest for 30 minutes.

### [Example 7]

Film formation and evaluation were performed on the same conditions and by the same method as in Example 1, except that in the cleaning process, the heater temperature was adjusted to achieve a nozzle temperature of 250°C and the nozzle 215, into which water mist was introduced, was kept at rest for 30 minutes.

### [Comparative Example]

Film formation and evaluation were performed on the same conditions and by the same method as in Example 1, except that in Example 1, the second substrate 210 was placed on the stage 207b without performing the cleaning process after dummy film formation.

Table 1 shows the results.

**[Table 1]**

| | Rocking curve full width at half maximum (seconds) | Film thickness (nm) | Film thickness variation (±%) | Particles on film (/cm²) |
|---|---|---|---|---|
| Example 1 | 7 | 583 | 1.7 | ≤29 |
| Example 2 | 6 | 578 | 3.1 | ≤29 |
| Example 3 | 9 | 581 | 3.0 | ≤29 |
| Example 4 | 8 | 572 | 2.8 | ≤29 |
| Example 5 | 7 | 569 | 3.3 | ≤29 |
| Example 6 | 9 | 591 | 2.9 | ≤29 |
| Example 7 | 7 | 570 | 2.7 | ≤29 |
| Comparative Example | 29 | 593 | 4.0 | 814 |

As described in Table 1, it has been found that in Examples 1 to 7 in which the crystalline oxide film 103 was formed by the film formation method for the crystalline oxide film 103 including the cleaning method of the present invention, particles adhering onto the film are significantly reduced compared to Comparative Example in which the crystalline oxide film 103 was formed without performing the cleaning. It is also seen that in Examples 1 to 7, the rocking curve full width at half maximum is smaller than in Comparative Example, and crystallinity is improved. This may be because foreign matter is inhibited from mixing in the crystalline oxide film 103.

As described above, it has been found that in Examples of the present invention, cleaning the nozzle 215 during the film forming process significantly reduces particles adhering onto the crystalline oxide film 103, resulting in a high-quality thin film with improved crystallinity.

The present description includes the following embodiments.
[1]: A nozzle cleaning method in a film formation apparatus comprising: a stage configured to heat a substrate placed on the stage; and a film formation unit including a nozzle configured to supply a mist of a film forming raw material, containing gallium, accompanied by a carrier gas to the substrate, the supplied mist reacting on the heated substrate to thereby form a crystalline oxide film containing gallium as a main component on the substrate,
   the method comprising a cleaning process, wherein a cleaning agent containing at least water in a liquid state or a gas state is supplied to the nozzle to remove a product adhering to the nozzle during film formation.
[2]: The nozzle cleaning method according to the above [1], wherein in the cleaning process,
   when supplying the cleaning agent to the nozzle, the temperature of the nozzle is set to 50 to 250°C.
[3]: The nozzle cleaning method according to the above [1] or [2], wherein in the cleaning process,
   water or water vapor containing acid is supplied as the cleaning agent.
[4]: The nozzle cleaning method according to any one of the above [1] to [3], wherein in the cleaning process,
   the cleaning agent is supplied to the nozzle as the mist.
[5]: The nozzle cleaning method according to any one of the above [1] to [4], wherein the stage is configured to be able to place the substrate with a diameter of 4 inches (100 mm) to 8 inches (200 mm).
[6]: The nozzle cleaning method according to any one of the above [1] to [5], wherein in the cleaning process,
   the nozzle is heated with a heating device that is different from a device that heats the stage.
[7]: A crystalline oxide film formation method, comprising:
   a film forming process including: supplying a mist of a film forming raw material, containing gallium, accompanied by a carrier gas through a nozzle to a substrate placed on a heated stage to cause the mist to react on the substrate; and forming a crystalline oxide film containing gallium as a main component on the substrate; and
   the cleaning process according to any one of the above [1] to [6], that is performed each time the film forming process is performed for a predetermined time.
[8]: A film formation apparatus comprising:
   a stage configured to heat a substrate placed on the stage;
   a film formation unit including a nozzle configured to supply a mist of a film forming raw material accompanied by a carrier gas to the substrate; and
   a raw material supply unit configured to supply the mist to the nozzle of the film formation unit, the supplied mist reacting on the heated substrate to thereby form a film on the substrate, the film formation apparatus further comprising:
      a cleaning agent supply unit configured to supply a cleaning agent containing at least water in a liquid state or a gas state to the nozzle.
[9]: The film formation apparatus according to the above [8], further comprising:
   a controller configured to control the raw material supply unit and the cleaning agent supply unit so as to perform cleaning, each time film formation is performed for a predetermined time, by supplying the cleaning agent from the cleaning agent supply unit to the nozzle to thereby remove a product adhering to the nozzle during the film formation.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A nozzle cleaning method in a film formation apparatus comprising: a stage configured to heat a substrate placed on the stage; and a film formation unit including a nozzle configured to supply a mist of a film forming raw material, containing gallium, accompanied by a carrier gas to the substrate, the supplied mist reacting on the heated substrate to thereby form a crystalline oxide film containing gallium as a main component on the substrate,
the method comprising a cleaning process, wherein a cleaning agent containing at least water in a liquid state or a gas state is supplied to the nozzle to remove a product adhering to the nozzle during film formation.

2. The nozzle cleaning method according to claim 1, wherein in the cleaning process,
when supplying the cleaning agent to the nozzle, the temperature of the nozzle is set to 50 to 250°C.

3. The nozzle cleaning method according to claim 1, wherein in the cleaning process,
water or water vapor containing acid is supplied as the cleaning agent.

4. The nozzle cleaning method according to claim 1, wherein in the cleaning process,
the cleaning agent is supplied to the nozzle as the mist.

5. The nozzle cleaning method according to claim 1, wherein the stage is configured to be able to place the substrate with a diameter of 4 inches (100 mm) to 8 inches (200 mm).

6. The nozzle cleaning method according to claim 1, wherein in the cleaning process,
the nozzle is heated with a heating device that is different from a device that heats the stage.

7. A crystalline oxide film formation method, comprising:
a film forming process including: supplying a mist of a film forming raw material, containing gallium, accompanied by a carrier gas through a nozzle to a substrate placed on a heated stage to cause the mist to react on the substrate; and forming a crystalline oxide film containing gallium as a main component on the substrate; and
the cleaning process according to any one of claims 1 to 6, that is performed each time the film forming process is performed for a predetermined time.

8. A film formation apparatus comprising:
a stage configured to heat a substrate placed on the stage;
a film formation unit including a nozzle configured to supply a mist of a film forming raw material accompanied by a carrier gas to the substrate; and
a raw material supply unit configured to supply the mist to the nozzle of the film formation unit, the supplied mist reacting on the heated substrate to thereby form a film on the substrate, the film formation apparatus further comprising:
a cleaning agent supply unit configured to supply a cleaning agent containing at least water in a liquid state or a gas state to the nozzle.

9. The film formation apparatus according to claim 8, further comprising:
a controller configured to control the raw material supply unit and the cleaning agent supply unit so as to perform cleaning, each time film formation is performed for a predetermined time, by supplying the cleaning agent from the cleaning agent supply unit to the nozzle to thereby remove a product adhering to the nozzle during the film formation.
